(19) Europäisches Patentamt / European Patent Office / Office européen des brevets

(11) **EP 3 021 484 B1**

(12) **FASCICULE DE BREVET EUROPEEN**

(45) Date de publication et mention de la délivrance du brevet:
**27.01.2021 Bulletin 2021/04**

(51) Int Cl.:
***H03H 7/40*** (2006.01)

(21) Numéro de dépôt: **15191601.2**

(22) Date de dépôt: **27.10.2015**

(54) **PROCEDE ET MODULE D'ADAPTATION AUTOMATIQUE D'IMPEDANCE, EN PARTICULIER POUR UNE CHAINE D'EMISSION OU RECEPTION RADIOFREQUENCE**

**VERFAHREN UND MODUL ZUR AUTOMATISCHEN IMPEDANZANPASSUNG, INSBESONDERE FÜR EINE FUNKEMISSIONS- UND EMPFANGSKETTE**

**METHOD AND DEVICE FOR AUTOMATICALLY ADAPTING IMPEDANCE, IN PARTICULAR FOR A CHANNEL TRANSMITTING OR RECEIVING RADIO FREQUENCIES**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **13.11.2014 FR 1460964**

(43) Date de publication de la demande:
**18.05.2016 Bulletin 2016/20**

(73) Titulaire: **COMMISSARIAT À L'ÉNERGIE ATOMIQUE ET AUX ÉNERGIES ALTERNATIVES 75015 Paris (FR)**

(72) Inventeur: **DE FOUCAULD, Emeric 38500 VOIRON (FR)**

(74) Mandataire: **Marks & Clerk France Immeuble "Visium" 22, avenue Aristide Briand 94117 Arcueil Cedex (FR)**

(56) Documents cités:
JP-A- H08 195 684    US-A1- 2007 194 859
US-A1- 2011 227 666    US-A1- 2013 069 737

## Description

L'invention porte sur un procédé d'adaptation automatique d'impédance d'une chaîne à radiofréquence, telle qu'une chaîne d'émission ou de réception à radiofréquence, et plus spécifiquement sur un procédé d'adaptation automatique d'antenne. L'invention porte également sur un module d'adaptation automatique d'impédance permettant la mise en œuvre d'un tel procédé, ainsi que sur des chaînes d'émission et de réception à radiofréquence comprenant un tel module d'adaptation automatique d'impédance.

Dans certaines applications de transmission d'informations en radiofréquence, on a constaté que l'antenne d'émission ou de réception pouvait avoir une impédance dépendant fortement de conditions extérieures à l'antenne, et dépendant notamment du milieu dans lequel l'antenne est placée.

Par exemple, dans la télémétrie médicale, on peut être amené à introduire l'antenne dans une sonde placée dans le corps humain, et l'impédance dépend alors fortement du milieu biologique dans lequel l'antenne se trouve. Elle dépend des propriétés électriques (conductivité, constante diélectrique) des tissus environnants (muscles, graisse) ou du milieu liquide (sang, autres liquides) dans lequel l'antenne peut être immergée.

Même dans des applications plus conventionnelles de transmission radiofréquence (téléphonie mobile, etc.) l'impédance de l'antenne peut varier.

De manière générale, les variations d'impédance d'antenne sont particulièrement sensibles pour des antennes de très petites dimensions ayant un fort coefficient de qualité, utilisées dans les applications à fortes contraintes de miniaturisation.

Ces variations d'impédance peuvent entraîner des pertes dites pertes de désadaptation : ces pertes résultent de ce que la chaîne d'émission qui alimente l'antenne, ou la chaîne de réception qui reçoit un signal de l'antenne, est en général conçue pour avoir des performances optimales lorsqu'elle est chargée (en sortie pour la chaîne d'émission ou en entrée pour la chaîne de réception) par une impédance nominale bien déterminée ; elle a des performances dégradées lorsqu'elle est chargée par une impédance différente de sa valeur nominale. Les pertes de désadaptation peuvent aller jusqu'à 40 dB.

C'est pourquoi il est connu d'interposer, entre la sortie d'un amplificateur de puissance et l'antenne d'une chaîne d'émission, un réseau d'adaptation d'impédance, en anglais « matching network », qui fait que la chaîne d'émission voit une impédance différente de celle de l'antenne et de préférence égale à la valeur nominale pour laquelle elle a été conçue, par exemple 100 ohms ou 500 ohms. Le réseau d'adaptation est accordable, c'est-à-dire que ses éléments, capacitifs et/ou inductifs, ont des valeurs ajustables pour tenir compte des conditions d'environnement de l'antenne de telle sorte que l'adaptation soit la meilleure possible quelles que soient les circonstances. De même, il est connu d'interposer un tel réseau d'adaptation d'impédance entre l'antenne d'une chaîne de réception et l'entrée d'un amplificateur à bas bruit.

Plusieurs techniques ont été proposées pour accorder de manière automatique un tel réseau d'adaptation, de manière à suivre, par exemple, des variations de l'impédance d'antenne induites par des conditions extérieures.

Le document US 4 375 051 enseigne l'utilisation, dans un chaîne d'émission, d'un coupleur bidirectionnel pour détecter une désadaptation par mesure de la fraction de la puissance fournie par un amplificateur qui est réfléchie par l'antenne. Cette mesure sert à asservir le réseau d'impédance pour modifier sa configuration dans un sens tendant à réduire la puissance réfléchie. Ce procédé souffre de deux inconvénients : d'une part la puissance réfléchie peut être faible et sujette à des interférences parasites, car toute interférence captée par l'antenne vient fausser la mesure du fait qu'elle s'additionne à la puissance réfléchie. D'autre part il n'y a pas de relation biunivoque entre la quantité de puissance réfléchie, qui sert d'entrée à l'asservissement, et la valeur complexe d'impédance qu'il faudrait donner au réseau d'adaptation pour adapter vraiment l'amplificateur à l'antenne. Ce procédé conduit donc à une nouvelle impédance qui n'est pas nécessairement optimale, car à une puissance donnée correspondent plusieurs couples d'impédances complexes.

Le document US 2009/0130991 divulgue un procédé d'ajustement des valeurs des réactances d'un circuit d'adaptation d'impédance agencé entre une antenne de réception et un amplificateur à bas bruit dans lequel les réactances des éléments dudit circuit d'adaptation sont ajustées itérativement de façon à maximiser l'intensité du signal de sortie dudit amplificateur à bas bruit. La convergence de l'algorithme d'optimisation itérative peut être très lente.

Les documents EP 2 037 576, WO 2011/026858, EP 2 509 222 et EP 2 509 227 décrivent diverses variantes d'un procédé d'adaptation automatique d'impédance d'une chaîne d'émission ou réception radiofréquence, dans lequel des mesures de courant et de tension à l'entrée (pour une chaîne d'émission) ou à la sortie (pour une chaîne de réception) du réseau d'adaptation permettent de déterminer l'impédance d'antenne. La connaissance ainsi obtenue de l'impédance d'antenne permet d'utiliser des techniques classiques, par exemple basées sur un abaque de Smith, pour ajuster les valeurs d'impédance des éléments du réseau d'adaptation de manière à parvenir à une adaptation d'impédance.

Le document US 2013/0069737 décrit un procédé d'adaptation automatique d'impédance d'une chaîne d'émission ou réception radiofréquence dans lequel l'on ne modifie pas seulement la valeur de réactance de certains éléments, mais aussi la topologie du réseau d'adaptation.

Un inconvénient des procédés d'adaptation automatique selon l'art antérieur est de ne pas prendre en compte les pertes introduites par le réseau d'adaptation d'impédance. Ces pertes trouvent leur origine dans le comportement non-idéal des éléments réactifs (condensateurs et selfs), dont l'impédance présente une composante résistive non nulle, et dans certains cas peuvent être supérieures au gain d'efficacité procuré par l'adaptation d'impédance.

L'invention vise à remédier aux inconvénients précités de l'art antérieur. Plus particulièrement elle vise à procurer un procédé d'adaptation automatique d'impédance permettant une prise en compte des pertes introduites par le réseau d'adaptation d'impédance, tout en étant simple à mettre en œuvre et convergeant rapidement. Elle vise également à procurer un module d'adaptation d'impédance permettant la mise en œuvre d'un tel procédé.

Conformément à l'invention, ce but est atteint grâce à :

- un réseau d'adaptation présentant, outre des éléments de réactance variable, une topologie reconfigurable ; et
- un processeur configuré ou programmé pour configurer ledit réseau d'adaptation en ajustant les valeurs de réactance desdits éléments et en déterminant sa topologie afin de réaliser une adaptation d'impédance tout en minimisant les pertes.

Un objet de l'invention est donc un procédé d'adaptation automatique d'impédance d'une chaîne à radiofréquence comprenant : un réseau d'adaptation d'impédance ayant une entrée et une sortie, un premier dispositif à radiofréquence connecté à ladite entrée et un deuxième dispositif à radiofréquence connecté à ladite sortie, ledit réseau d'adaptation d'impédance présentant une topologie reconfigurable et comprenant une pluralité d'éléments réactifs dont au moins un présente une réactance variable, le procédé comprenant :

- la mesure d'au moins un courant et une tension à l'entrée ou à la sortie dudit réseau d'adaptation d'impédance ;
- la détermination, par un processeur de données recevant en entrée les résultats desdites mesures, d'une topologie dudit réseau d'adaptation et d'une valeur de réactance dudit ou de chaque dit élément réactif de manière à optimiser conjointement l'adaptation d'impédance entre ledit premier et ledit deuxième dispositif à radiofréquence et le rendement de puissance dudit réseau d'adaptation ; et
- la configuration dudit réseau d'adaptation d'impédance de telle sorte qu'il prenne ladite topologie et que ledit ou de chaque dit élément réactif présentant une réactance variable prenne ladite valeur de réactance.

Plus précisément, le procédé comporte les étapes suivantes :

a) mesurer au moins un courant et une tension à l'entrée ou à la sortie dudit réseau d'adaptation d'impédance ;

b) calculer une impédance complexe $Z_m$, définie par le rapport entre la tension et le courant mesurés en tenant compte de leur déphasage et représentant une impédance d'entrée dudit réseau d'adaptation d'impédance ou une impédance de sortie dudit réseau d'adaptation d'impédance à radiofréquence, selon que les mesures de l'étape a) aient été effectuées à l'entrée ou à la sortie dudit réseau d'adaptation d'impédance ;

c) à partir de ladite impédance complexe $Z_m$, de la topologie et des valeurs actuelles connues des éléments réactifs dudit réseau d'adaptation d'impédance, calculer la valeur d'une impédance complexe $Z_d$ représentative d'une impédance de sortie dudit premier dispositif à radiofréquence ou d'une impédance d'entrée dudit deuxième dispositif à radiofréquence, selon que les mesures de l'étape a) aient été effectuées à l'entrée ou à la sortie dudit réseau d'adaptation d'impédance ;

d) pour une pluralité de topologies possibles dudit réseau d'adaptation d'impédance, calculer des nouvelles valeurs de réactance dudit ou de chaque dit élément réactif présentant une réactance variable, de telle sorte que l'impédance de charge $Z_{DME}$ dudit premier dispositif à radiofréquence ou l'impédance d'entrée $Z_{DSM}$ dudit deuxième dispositif à radiofréquence prenne une valeur aussi proche que possible d'une valeur nominale prédéfinie $Z_{opt}$ ;

e) choisir, parmi lesdites topologies dudit réseau d'adaptation d'impédance, celle qui minimise les pertes lorsque la réactance dudit ou de chaque dit élément réactif présentant une réactance variable prend la valeur calculée à l'étape d) ; et

f) configurer le réseau d'adaptation d'impédance de telle sorte qu'il prenne la topologie déterminée à l'étape e) et que la réactance dudit ou de chaque dit élément réactif présentant une réactance variable prenne la valeur calculée à l'étape d).

Selon différents modes de réalisation :

- Les mesures de l'étape a) peuvent être effectuées à la sortie dudit réseau d'adaptation d'impédance, le procédé comprenant également l'étape suivante, mise en œuvre après ladite étape f) :
g) calculer la puissance électrique en sortie dudit réseau d'adaptation d'impédance à partir de la tension et du courant mesurés, et ajuster itérativement la réactance dudit ou de chaque dit élément réactif présentant une réactance variable de manière à maximiser ladite puissance électrique.
- Ledit premier dispositif à radiofréquence peut être ou comprendre un amplificateur de puissance et ledit deuxième dispositif à radiofréquence peut être ou comprendre une antenne.

- Ledit premier dispositif à radiofréquence peut être ou comprendre une antenne et ledit deuxième dispositif à radiofréquence peut être ou comprendre un amplificateur à bas bruit.

- Ledit premier dispositif à radiofréquence peut être ou comprendre une antenne et ledit deuxième dispositif à radiofréquence peut être ou comprendre un amplificateur à bas bruit, le procédé comprenant également l'étape suivante, mise en œuvre après ladite étape f) :

g') mesurer la puissance électrique en sorite dudit amplificateur à bas bruit, et ajuster itérativement la réactance dudit ou de chaque dit élément réactif présentant une réactance variable de manière à maximiser ladite puissance électrique.

Un autre objet de l'invention est un module d'adaptation automatique d'impédance configuré pour être agencé entre un premier dispositif à radiofréquence et un deuxième dispositif à radiofréquence, ledit module comprenant : un réseau d'adaptation d'impédance ayant une entrée configurée pour être reliée audit premier dispositif à radiofréquence et une sortie configurée pour être reliée audit deuxième dispositif à radiofréquence, ledit réseau d'adaptation d'impédance comprenant une pluralité d'éléments réactifs dont au moins un présente une réactance variable ; un dispositif de mesure de courant et de tension, agencé pour mesurer un courant et une tension à l'entrée ou à la sortie dudit réseau d'adaptation d'impédance ; au moins un premier dispositif de configuration dudit réseau d'adaptation d'impédance, configuré pour modifier la réactance dudit ou de chaque dit élément réactif présentant une réactance variable ; et un processeur de données configuré pour recevoir en entrée des mesures de courant et de tension en provenance dudit dispositif de mesure et pour fournir en sortie des signaux de pilotage dudit ou desdits premiers dispositifs de configuration ; où : ledit réseau d'adaptation d'impédance présente une topologie reconfigurable ; le module comprend également au moins un deuxième dispositif de configuration dudit réseau d'adaptation d'impédance, configuré pour modifier sa topologie ; ledit processeur de données est configuré pour déterminer une topologie dudit réseau d'adaptation et une valeur de réactance dudit ou de chaque dit élément réactif de manière à optimiser conjointement l'adaptation d'impédance entre ledit premier et ledit deuxième dispositif à radiofréquence et le rendement de puissance dudit réseau d'adaptation, et pour générer des signaux de pilotage desdits premiers et deuxièmes dispositifs de configuration adaptés pour que lesdits dispositifs configurent le réseau d'adaptation d'impédance de telle sorte qu'il prenne ladite topologie et que ledit ou de chaque dit élément réactif présentant une réactance variable prenne ladite valeur.

Plus précisément ledit processeur de est configuré pour : calculer une impédance complexe $Z_m$, définie par le rapport entre la tension et le courant mesurés par ledit dispositif de mesure en tenant compte de leur déphasage et représentant une impédance d'entrée dudit réseau d'adaptation d'impédance ou une impédance de sortie dudit réseau d'adaptation d'impédance , selon que ledit dispositif de mesure soit agencé pour effectuer des mesures à l'entrée ou à la sortie dudit réseau d'adaptation d'impédance ; à partir de ladite impédance complexe $Z_m$, de la topologie et des valeurs actuelles connues des éléments réactifs dudit réseau d'adaptation d'impédance, calculer la valeur d'une impédance complexe $Z_d$ représentative d'une impédance de sortie dudit premier dispositif à radiofréquence (DRF1) ou d'une impédance de sortie dudit deuxième dispositif à radiofréquence (DRF2), selon que ledit dispositif de mesure soit agencé pour effectuer des mesures à l'entrée ou à la sortie dudit réseau d'adaptation d'impédance ; pour une pluralité de topologies possibles dudit réseau d'adaptation d'impédance, calculer des nouvelles valeurs de réactance dudit ou de chaque dit élément réactif présentant une réactance variable, de telle sorte que l'impédance de charge $Z_{DME}$ dudit premier dispositif (DRF1) à radiofréquence ou l'impédance ou l'impédance d'entrée $Z_{DSM}$ dudit deuxième dispositif à radiofréquence (DRF2) prenne une valeur aussi proche que possible d'une valeur nominale prédéfinie $Z_{opt}$ ; choisir, parmi lesdites topologies dudit réseau d'adaptation d'impédance, celle qui minimise les pertes lorsque la réactance dudit ou de chaque dit élément réactif présentant une réactance variable prend la valeur calculée ; générer des signaux de pilotage desdits premiers et deuxièmes dispositifs de configuration adaptés pour que lesdits dispositifs configurent le réseau d'adaptation d'impédance de telle sorte qu'il prenne la topologie choisie et que ledit ou de chaque dit élément réactif présentant une réactance variable prenne la valeur calculée.

Selon différents modes de réalisation :

- Ledit processeur de données peut être également configuré pour recevoir en entrée une mesure de puissance électrique, ou des données permettant de calculer une puissance électrique, et pour générer des signaux de pilotage dudit ou desdits premiers dispositifs de configuration adaptés pour que lesdits dispositifs ajustent itérativement la réactance dudit ou de chaque dit élément réactif présentant une réactance variable de manière à maximiser ladite puissance électrique.

- En outre, ledit processeur de données peut être configuré pour calculer ladite puissance électrique à partir des mesures de courant et de tension en provenance dudit dispositif de mesure.

- En variante, ledit module d'adaptation d'impédance peut comprendre également un dispositif de mesure de puissance agencé pour mesurer une puissance électrique de sortie dudit deuxième dispositif à radiofréquence et pour fournir un résultat de mesure audit processeur de données.

Encore un autre objet de l'invention est une chaîne d'émission radiofréquence comprenant un amplificateur de puissance, une antenne et un tel module d'adaptation automatique d'impédance connecté entre une sortie dudit amplificateur de puissance et un port d'entrée de ladite antenne.

Encore un autre objet de l'invention est une chaîne de réception radiofréquence comprenant une antenne, un amplificateur à bas bruit et un tel module d'adaptation automatique d'impédance connecté entre un port de sortie de ladite antenne et une entrée dudit amplificateur à bas bruit.

On entend par « radiofréquence » toute fréquence comprise entre 3 kHz et 300 GHz.

On entend par « amplificateur de puissance » un amplificateur dont une sortie est reliée ou destinée à être reliée, de manière directe ou indirecte, à une antenne émettrice.

On entend par « amplificateur à bas bruit » un amplificateur dont une entrée est reliée ou destinée à être reliée, de manière directe ou indirecte, à une antenne réceptrice.

On entend par « élément réactif » un composant électrique dont l'impédance présente, à au moins une fréquence dans le domaine radiofréquence, une composante réactive (capacitive ou inductive) supérieure ou égale - et de préférence supérieure d'un facteur 10 ou plus - à sa composante résistive.

La « topologie » d'un réseau électrique est définie par l'ensemble des éléments qui le composent (condensateurs, selfs, résistances...) et leur interconnexion, en faisant abstraction de la valeur de leur résistance, inductance ou capacité. Il est entendu que plusieurs éléments d'un même type connectés en série ou en parallèle sont considérés comme constituant un seul élément. Ainsi on ne change pas de topologie en remplaçant, par exemple, un condensateur unique par deux condensateurs connectés en parallèle.

On considérera dans la suite que les signaux dans le réseau d'adaptation présentent une fréquence unique f=2πω, ce qui permet de caractériser un élément capacitif ou inductif (élément réactif) par une valeur de réactance. Cette approximation est généralement satisfaisante dans le domaine des radiofréquences.

D'autres caractéristiques, détails et avantages de l'invention ressortiront à la lecture de la description faite en référence aux dessins annexés donnés à titre d'exemple et qui représentent, respectivement :

- La figure 1A, le schéma fonctionnel d'un module d'adaptation automatique d'impédance selon un mode de réalisation de l'invention ;
- La figure 1B, le schéma électrique du réseau d'adaptation d'impédance du module de la figure 1A ;
- La figure 2, l'ordinogramme d'un procédé d'adaptation automatique d'impédance selon un mode de réalisation de l'invention ;
- Les figures 3 et 4, respectivement, les schémas fonctionnels d'une chaîne d'émission à radiofréquence et d'une chaîne de réception à radiofréquence selon des modes de réalisation respectifs de l'invention ; et
- La figure 5, le schéma électrique équivalent d'un réseau d'adaptation d'impédance en « Pi », utilisé pour calculer son rendement de puissance.

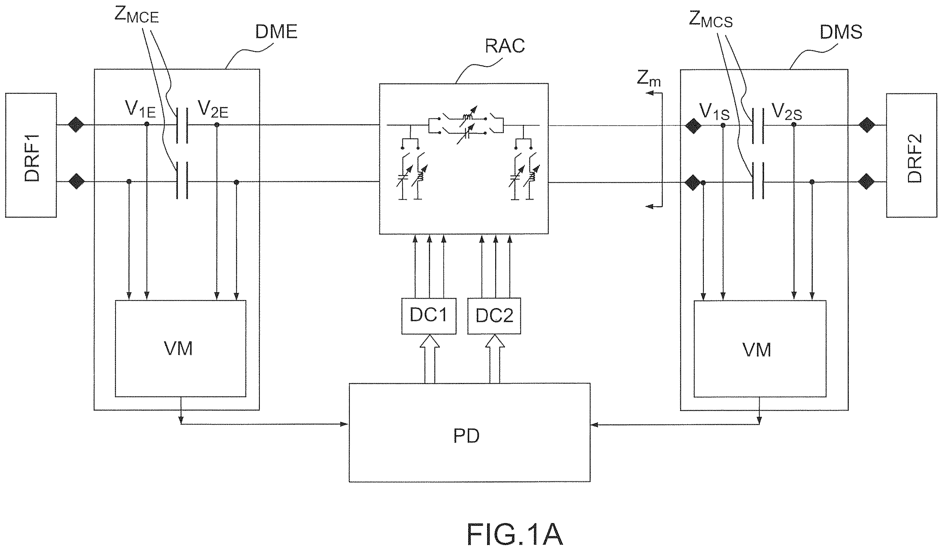

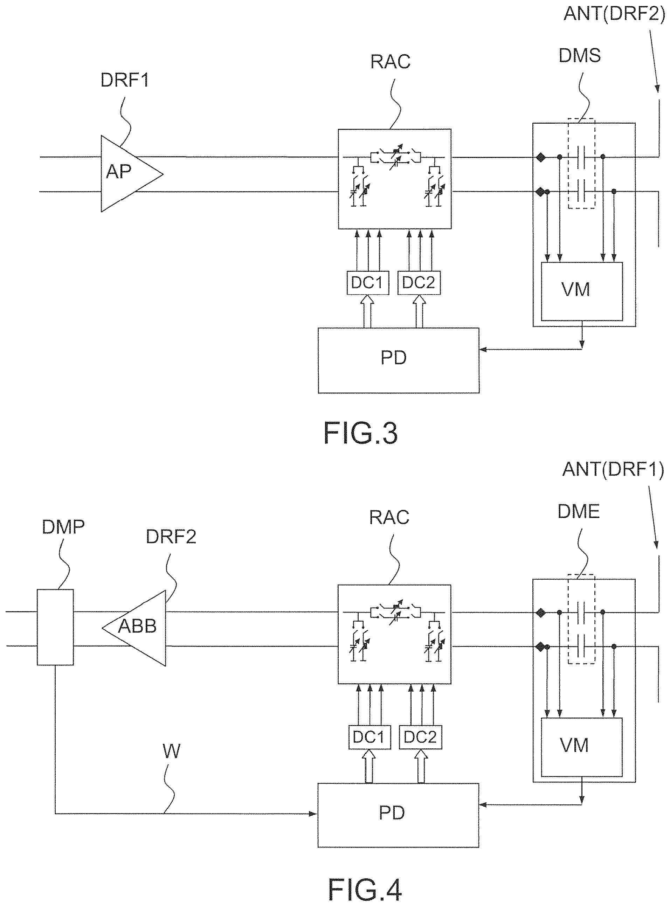

La figure 1A représente le schéma de principe fonctionnel d'un module d'adaptation automatique d'impédance selon un mode de réalisation de l'invention, inséré dans une chaîne à radiofréquence. Le module comprend un réseau d'adaptation d'impédance configurable RAC ayant deux portes, deux dispositifs de mesure DME, DMS agencés au niveau desdites portes (mais en fait un seul peut suffire), un processeur de données PD recevant en entrée des données de mesure générés par lesdits dispositifs de mesure et générant des signaux de pilotage pour deux dispositifs de commande DC1, DC2 qui configurent le réseau RAC. Les deux portes du réseau d'adaptation d'impédance RAC sont reliées à un premier dispositif à radiofréquence DRF1 et à un deuxième dispositif à radiofréquence DRF2, respectivement. Dans la suite, sauf indication contraire, on considérera que le premier dispositif à radiofréquence DRF1 est un amplificateur de puissance AP et que le deuxième dispositif à radiofréquence DRF2 est une antenne ANT fonctionnant en émission (voir la figure 3), moyennant quoi la chaîne à radiofréquence est une chaîne d'émission ; des filtres peuvent également être prévus entre l'amplificateur et le réseau d'adaptation d'impédance et/ou entre ce dernier et l'antenne. D'autres cas sont également possibles, en particulier le premier dispositif à radiofréquence DRF1 peut être une antenne ANT fonctionnant en réception et le deuxième dispositif à radiofréquence DRF2 peut être un amplificateur à bas bruit ABB, moyennant quoi la chaîne à radiofréquence est une chaîne de réception.

Dans la suite on considèrera toujours que la puissance électrique se propage de DRF1 vers DRF, de telle sorte que le dispositif de mesure DME est agencé au niveau de l'entrée du réseau d'adaptation d'impédance et le dispositif de mesure DMS est agencé au niveau de la sortie de ce dernier.

Les dispositifs de mesure DME, DMS permettent de mesurer la tension et le courant d'entrée et de sortie du réseau d'adaptation, respectivement. Ces dispositifs peuvent notamment être du type décrit dans le document EP 2 037 576 précité, et comprendre :

- une impédance $Z_{MCE}$, $Z_{MCS}$ connecté en série ;
- un dispositif VM permettant de mesurer la tension en amont et en aval de cette impédance.

De préférence, les impédances de mesure $Z_{MCE}$, $Z_{MCS}$ sont réactive, et de manière encore préférée, capacitives. Dans l'exemple de la figure 1A, les mesures sont effectuées en mode différentiel, de telle sorte que chaque dispositif de mesure comprend deux capacités de mesure identique, mais cela n'est pas essentiel.

Chaque dispositif VM est essentiellement constitué par un circuit de changement de fréquence classique et un convertisseur analogique-numérique. En effet, les tensions aux bornes des impédances de mesure sont des signaux électriques à la fréquence porteuse f. Pour réduire la consommation électrique, et améliorer la précision de calcul, il peut être intéressant d'effectuer le calcul d'impédance à basse fréquence. Il est alors prévu une conversion à une fréquence plus basse pour pouvoir faire les calculs qui suivent. On notera que dans certains cas on peut utiliser, pour constituer ce circuit de mesure, des éléments de circuits présents dans les circuits de réception radiofréquence du système. En effet si le système fonctionne en émission et en réception, la partie réception comporte des circuits de changement de fréquence et ces circuits peuvent très bien servir pour effectuer les mesures de tension.

La mesure chute de tension $V_{1S}$-$V_{2S}$ ($V_{2E}$-$V_{1E}$) aux bornes de l'impédance $Z_{MCS}$ ($Z_{MCE}$) permet de déterminer le courant de sortie (d'entrée) du réseau d'adaptation. La tension de sortie (d'entrée) du réseau d'adaptation est mesurée directement par le dispositif VM.

En calculant le rapport et le déphasage entre le courant et la tension de sortie du réseau d'adaptation, mesurés par le dispositif $Z_{MCS}$, on peut donc déterminer une impédance complexe $Z_m$ qui représente l'impédance de sortie du réseau d'adaptation. De même, en calculant le rapport et le déphasage entre le courant et la tension d'entrée du réseau d'adaptation, mesurés par le dispositif $Z_{MCS}$, on peut déterminer une impédance complexe qui représente l'impédance d'entrée du réseau d'adaptation, et donc l'impédance de charge du dispositif à radiofréquence DRF1 (l'amplificateur, dans une chaîne d'émission).

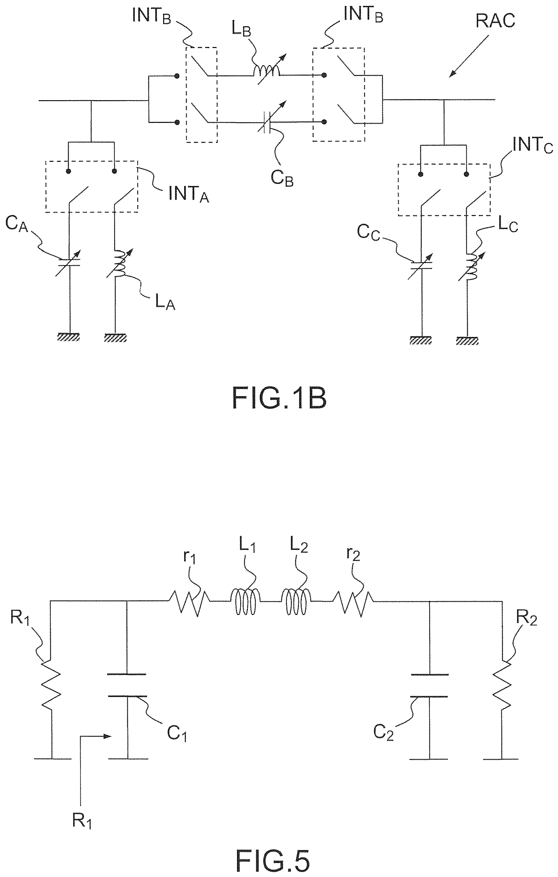

La figure 1B montre le schéma d'un mode de réalisation possible du réseau d'adaptation d'impédance RAC. Ce réseau est reconfigurable à double titre : d'une part, un ensemble d'interrupteurs commandés $INT_A$, $INT_B$, $INT_C$ permet d'en modifier la topologie ; d'autre part, il comprend un ensemble d'éléments réactifs $C_A$, $C_B$, $C_c$, $L_A$, $L_B$, $L_C$ dont au moins certains (un au minimum, de préférence plusieurs) présentent une réactance variable. Dans l'exemple de la figure 1B, donné à titre non limitatif, le réseau présente une configuration généralement en « Pi » avec une branche centrale et deux branches latérales ou jambes. En fonction de la configuration des interrupteurs, chacune de ces branches peut être capacitive, inductive ou constituer un circuit LC parallèle ; en outre, les jambes peuvent être déconnectées. Ainsi, par exemple, il est possible d'agir sur les interrupteurs pour configurer le réseau d'adaptation d'impédance pour qu'il prenne une topologie choisie parmi les suivantes : topologie en Pi avec jambes capacitives et branche centrale inductive ; topologie en Pi avec jambes inductives et branche central capacitive ; simple circuit RC parallèle connecté en série entre le premier et le deuxième dispositif à radiofréquence.

Dans l'exemple de la figure 1B, tous les éléments réactifs du réseau d'adaptation d'impédance présentent une réactance (et donc une inductance ou une capacité) variable, mais cela n'est pas essentiel.

Un premier dispositif de configuration DC1 pilote les interrupteurs $INT_A$, $INT_B$, $INT_C$, déterminant ainsi la topologie du réseau d'adaptation d'impédance RAC. Un deuxième dispositif de configuration DC2 agit - électriquement et/ou mécaniquement - sur les éléments réactifs $C_A$, $C_B$, $C_c$, $L_A$, $L_B$, $L_C$ pour modifier leur réactance. Ces dispositifs de configuration sont à leur tour pilotés par le processeur de données PD, voire ils sont intégrés dans ce dernier. Par exemple, le premier dispositif de configuration peut comprendre des circuits électronique de pilotage des interrupteurs $INT_A$, $INT_B$, $INT_C$ et le deuxième dispositif de configuration des générateurs de tension permettant de varier la capacité de diodes à capacité variable et des générateurs de courant permettant de varier l'inductance de selfs présentant un noyau saturable ; il existe également des inductances commandées en tension, ainsi que des inductances accordables de type micro-électromécanique (MEMS), voir par exemple :

- Casha, O. ; Grech, I. ; Micallef, J. ; Gatt, E. ; Morche, D. ; Viala, B.; Michel, J.P. ; Vincent, P. ; de Foucauld, E. : « Utilization of MEMS Tunable Inductors in the design of RF voltage-controlled oscillators », 15th IEEE International Conference on Electronics, Circuits and Systems, 2008. ICECS 2008 ;
- L. Collot, J. Lintignat, B. Viala, D. Morche, J-P. Michel, B. Barelaud, B. Jarry « Reconfigurable Filtering Differential Low Noise Amplifier Using MEMS Tunable Inductor » Proceedings of the 40th European Microwave Conference, 2010 , Pages: 826 - 829

Le processeur de données PD est typiquement un microprocesseur programmé de manière opportune, mais il peut également s'agir d'un circuit numérique configuré de manière matérielle, ou d'une combinaison des deux. Ce processeur réalise les opérations suivantes :

- A partir des mesures de tension et de courant réalisées par le dispositif de mesure DME et/ou DMS, il détermine l'impédance d'entrée et/ou de sortie du réseau d'adaptation d'impédance.
- A partir de l'impédance d'entrée et/ou de sortie du réseau d'adaptation, de ce dernier (topologie et valeur des réactances), il détermine la valeur de l'impédance du dispositif DRF1 ou du dispositif DRF2. Typiquement, dans le cas d'une chaîne d'émission ou de réception à radiofréquence, il s'agira de déterminer l'impédance de l'antenne - correspondant à DRF2 dans une chaîne d'émission et à DRF1 dans une chaîne de réception.
- Il détermine la valeur que doivent prendre les réactances des éléments variables du réseau d'adaptation d'impédance pour réaliser une adaptation d'impédance de la chaîne à radiofréquence. Typiquement, dans une chaîne d'émission il s'agira de faire en sorte que l'impédance de charge de l'amplificateur de puissance (DRF1) soit égale, ou aussi proche que possible, d'une impédance optimale prédéfinie (généralement, l'impédance de sortie dudit amplificateur). De même, dans le cas d'une chaîne de réception il s'agira de faire en sorte que l'impédance à l'entrée de l'amplificateur à bas bruit (DRF2) soit égale, ou aussi proche que possible, d'une impédance optimale prédéfinie (généralement, l'impédance d'entrée dudit amplificateur). Ce calcul est répété pour chaque topologie possible (ou au moins pour un ensemble prédéfini de topologies possibles) du réseau RAC. On obtient ainsi une pluralité de configurations admissibles du réseau RAC, présentant des topologies différentes et permettant toutes de réaliser une adaptation d'impédance.

- Parmi ces configurations admissibles, il sélectionne celle qui présente le meilleur rendement de puissance, et donc les plus faibles pertes. Pour cela, il doit disposer d'une caractérisation des différents éléments réactifs du réseau d'adaptation. Puis, il commande les dispositifs de configuration DC1, DC2 du réseau d'adaptation en conséquence.

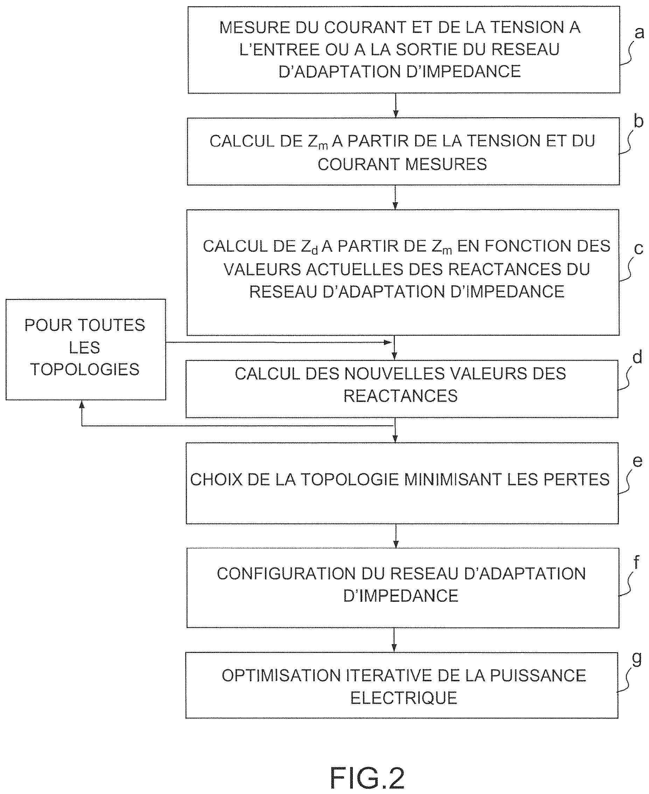

Ces différentes opérations correspondent aux étapes « b », « c », « d » et « e » de l'ordinogramme de la figure 2. L'étape « a » correspond aux opérations de mesure, réalisées par le dispositif DME et/ou DMS, tandis que l'étape « f » correspond à la configuration du réseau RAC par les dispositifs DC1 et DC2.

L'étape « g » est optionnelle. Elle consiste à ajuster de manière itérative les valeurs d'impédance - à l'aide du dispositif de configuration DC2 piloté par le processeur PD - de manière à optimiser la puissance électrique en sortie du réseau d'adaptation, voire la puissance électrique mesurée en un autre point de la chaîne à radiofréquence. L'idée qui sous-tend cette étape est que parfois il peut être avantageux d'accepter une légère désadaptation d'impédance si elle s'accompagne d'une réduction significative des pertes introduites par le réseau d'adaptation.

Dans le cas d'une chaîne d'émission, il est pertinent de maximiser la puissance en sortie du réseau d'adaptation, qui est fourni à l'antenne ANT ; cette puissance peut être calculée à partir du courant et de la tension de sortie du réseau RAC, mesurés par le dispositif DMS. L'utilisation d'un dispositif de mesure en entrée, DME, n'est pas nécessaire (figure 3).

Dans le cas d'une chaîne de réception, par contre, il est préférable de maximiser la puissance W en sortie de l'amplificateur à bas bruit ABB, ce qui nécessite un dispositif de mesure dédié DMP, qui peut présenter une structure semblable à celle de DMS et DME. Ce montage est illustré sur la figure 4. Dans l'exemple illustré par cette figure, en outre, le dispositif de mesure DME est présent, mais DMS est absent ; l'inverse aurait également été possible.

L'utilisation d'un dispositif de mesure de la puissance distinct du ou des dispositifs de mesure utilisé(s) pour réaliser l'adaptation d'impédance est également possible dans le cas d'une chaîne d'émission. Cela est particulièrement avantageux si on souhaite réaliser les mesures de courant et de tension utilisées pour l'adaptation automatique d'impédance à l'entrée du réseau d'adaptation, et non à sa sortie.

Il convient de noter que l'étape « g » peut également être mise en œuvre lorsque le réseau d'adaptation d'impédance présente une topologie fixe (auquel cas l'étape « d » est exécutée une seule fois et l'étape « e » n'a pas raison d'être). Par rapport au procédé décrit dans le document US 2009/0130991 précité, la convergence est plus rapide car l'optimisation itérative commence d'une situation d'adaptation d'impédance, qui est déjà proche de l'optimalité.

Dans la suite, la mise en œuvre des étapes « b » à « e » et « g » sera décrite en plus en détail en référence au cas spécifique illustré sur la figure 3, à savoir une chaîne d'émission avec mesure du courant et de la tension en sortie du circuit d'adaptation d'impédance. La génération à d'autres cas, comme celui d'une chaîne de réception ne pose pas de difficulté particulière.

Etape « b » : calcul de l'impédance de charge actuelle.

Le circuit de mesure DMS reçoit les signaux de tension $V_{1S}$ et $V_{2S}$ définis précédemment. Ces tensions sont à la fréquence porteuse f ; elles sont de préférence ramenées à une fréquence intermédiaire ou en bande de base par des circuits de changement de fréquence classiques utilisant un oscillateur local et des mélangeurs. Puis les niveaux de tension $V_{1S}$ et $V_{2S}$, ramenés à cette fréquence intermédiaire ou en bande de base, sont utilisés pour calculer le courant vectoriel i qui traverse l'impédance de mesure $Z_{MCS}$ et donc l'impédance complexe $V_{1S}/i$ vue par l'amplificateur. Les déphasages sont conservés dans le changement de fréquence.

Le module de i est le rapport du module de $V_{1S}$ et du module de l'impédance $Z_{DMS}$ ; le déphasage de i par rapport à la tension $V_{1S}$ est un angle $\theta$ qui représente l'argument de l'impédance $Z_m$. Cet angle peut être déterminé à partir du déphasage entre $V_{1S}$ et $V_{2S}$ auquel on soustrait $\pi/2$ sachant que le déphasage entre i et $(V_{1S}-V_{2S})$ est de $\pi/2$ puisque, dans le mode de réalisation de la figure 1, $Z_{MCS}$ est une impédance capacitive: $Z_{MCS}=1/(j\omega C_{MCS})$, où « j » est l'unité imaginaire, $\omega$ la fréquence du signal à radiofréquence et $C_{MCS}$ la capacité du condensateur qui constitue l'impédance de mesure.

Le déphasage entre $V_{1S}$ et $V_{2S}$ peut être calculé par exemple en multipliant les signaux analogiques $V_{1S}$ et $V_{2S}$, ramenés en bande de base, et en observant la variation périodique du produit des deux signaux. Ce produit oscille entre une valeur maximum positive et une valeur minimum négative. La somme algébrique de ces deux valeurs est proportionnelle au cosinus du déphasage et le coefficient de proportionnalité est la différence algébrique de ces deux valeurs. Par conséquent, en faisant le rapport entre la somme des deux valeurs et la différence des deux valeurs on trouve le cosinus du déphasage dont on tire le déphasage entre $V_{1S}$ et $V_{2S}$, d'où on déduit le déphasage entre $V_{1S}$ et i. D'autres méthodes de calcul numérique du déphasage peuvent être utilisées, par exemple par numérisation des deux signaux $V_{1S}$ et $V_{2S}$ sur un bit, égal à 1 lorsque le signal est positif et à 0 lorsqu'il est négatif. Le décalage temporel des trains d'impulsions de bits 1 résultant de la numérisation de $V_{1S}$, par rapport aux mêmes trains d'impulsions correspondant à la numérisation de $V_{2S}$, représente le déphasage entre $V_{1S}$ et $V_{2S}$. Le signe du déphasage est repéré en observant les fronts de montée des signaux ainsi numérisés sur un bit ; ceci peut se faire par une bascule D qui reçoit sur une entrée de signal l'une des tensions $V_{1S}$ ou $V_{2S}$ et sur une entrée d'horloge l'autre de ces tensions, et qui reporte à sa sortie l'état de l'entrée de signal au moment d'un front de montée sur l'entrée d'horloge.

Une fois qu'on a l'argument θ de l'impédance $Z_m$, on peut calculer aisément sa partie réelle et sa partie imaginaire.

Etape « c » : calcul de l'impédance actuelle de l'antenne.

A partir de cette mesure de $Z_m$, connaissant la configuration du réseau d'adaptation (topologie et valeurs numériques actuelles des capacités et inductances), et également la valeur numérique de la capacité de mesure $Z_{MCS}$ , on peut calculer l'impédance de l'antenne.

Ce calcul est immédiat, car on a simplement : $Z_d=Z_m-Z_{MCS}$

Etape « d » : calcul de valeurs modifiées pour les réactances du réseau d'adaptation.

Connaissant à la fois l'impédance actuelle de l'antenne $Z_d$ et l'impédance équivalente du réseau d'adaptation Zeq, fonction de ($C_A$, $C_C$, $L_B$), ainsi que l'impédance de mesure $Z_{MCS}$, il s'agit de calculer les valeurs $C_A$, $C_C$ $L_B$ qu'il faut donner aux éléments variables pour que l'impédance de l'ensemble $Z_{DME}$, telle qu'elle sera vue aux bornes de l'amplificateur (et donc à l'entrée du réseau d'adaptation) soit égale à la valeur nominale $Z_{opt}$ (généralement, l'impédance de sortie de l'amplificateur) : $Z_{DME}=Z_{opt}$.

Pour ce faire on peut avoir recours à des techniques bien connues de l'homme du métier, basées par exemple sur l'utilisation d'un abaque de Smith. Le document EP 2 037 576 précité fournit un exemple d'application d'une telle méthode. Contrairement au cas étudié dans ce document, cependant, dans le cadre de la présente invention le dimensionnement du réseau d'adaptation RAC est répété une pluralité de fois en considérant différentes topologies possibles. Par exemple, dans le cas du réseau configurable de la figure 1B, on peut prendre en compte deux topologies distinctes : une topologie en « Pi » avec branche centrale inductive et jambes capacitives (il s'agit de la topologie utilisée pour la mesure de $Z_m$), et une topologie également en « Pi » mais avec branche centrale capacitive et jambes inductives.

Etape « e » : calcul du rendement de puissance (ou, de manière équivalente, des pertes).

La figure 5 montre un schéma équivalent du circuit d'adaptation d'impédance de la figure 1B dans sa configuration en « Pi » avec branche centrale inductive et jambes capacitives, placé dans la chaîne à radiofréquence de la figure 3. La résistance équivalente $R_1$ représente l'effet combiné de l'impédance de sortie de l'amplificateur de puissance PA, supposée connue et purement résistive, et de la résistance parasite de la capacité $C_A$; $C_1$ est, dans ce cas particulier, égal à $C_A$. La résistance équivalente $R_2$ représente l'effet combiné de l'impédance d'entrée de l'antenne $Z_d$, mesurée lors de l'étape « c » et considérée purement résistive, et de la résistance parasite des capacités $C_B$ et $Z_{DMS}$ ; $C_2$ est une capacité équivalente rendant compte des effets capacitifs dus à $C_B$ et $Z_{DMS}$. L'élément inductif $L_B$ est scindé en deux parties $L_1$ et $L_2$ pour des raisons de commodité de calcul, avec $L_1+L_2=L_B$. Il en va de même pour sa résistance parasite $r_L=r_1+r_2$.

A ce point on peut définir les facteurs de qualité $Q_{C1}$, $Q_{C2}$, $Q_{L1}$, $Q_{L2}$ des éléments équivalents $C_1$, $C_2$, $L_1$ et $L_2$ :

$$Q_{C1} = \omega R_1 C_1$$

$$Q_{C2} = \omega R_2 C_2$$

$$Q_{L1} = \frac{\omega L_1}{r_1}$$

$$Q_{L2} = \frac{\omega L_2}{r_2}$$

Le rendement en puissance η est alors donné par

$$\eta = \frac{1}{1 + \left[\frac{Q_{C1}}{Q_{L1}} + \frac{Q_{C2}}{Q_{L2}}\right]}$$

On peut vérifier que la valeur de η ne dépend pas de la façon dont on décompose $L_B=L_1+L_2$.

On remarque que le rendement $\eta$ dépend de la valeur de $C_1$, $C_2$, $L_1$ et $L_2$ et donc de $C_A$, $L_B$ et $C_C$ ; ainsi, il varie lorsqu'on ajuste la valeur de réactance des éléments du réseau d'adaptation RAC pour réaliser une adaptation d'impédance. Par ailleurs, la valeur des résistances parasites peut également varier lors de cet ajustement.

Une méthode générale de calcul de rendement, pouvant être appliquée à une topologie arbitraire, est détaillée dans l'article de Yehui Han et David J. Perreault « Analysis and Design of High Efficiency Matching Networks », IEEE Transactions on Power Electronics, Vol. 21, No. 5, septembre 2006, pages 1484 - 1491.

Il est donc possible de calculer la valeur du rendement $\eta$ pour toutes les configurations du réseau RAC déterminées lors de l'étape « d », puis de choisir celle qui présente la valeur de rendement la plus élevée.

Etape « g » : optimisation itérative de la puissance en sortie du réseau d'adaptation.

Cette dernière étape, optionnelle, consiste à faire varier itérativement les réactances du réseau RAC autours des valeurs déterminées lors de l'étape « d », sans modifier la topologie du réseau choisie suite à l'étape « f », cela dans le but de maximiser la puissance transmise à l'antenne et mesurée grâce au dispositif DMS. Contrairement aux étapes précédentes, l'optimisation se fait en agissant sur le circuit réel et en mesurant la puissance effectivement transmise, et pas sur la base de calculs utilisant un modèle du circuit. Cette optimisation itérative permet de tenir compte du fait qu'une légère désadaptation d'impédance peut être plus que compensée par une réduction du niveau de pertes dans le circuit d'adaptation. Elle permet aussi de corriger les imprécisions inhérentes aux modèles utilisés pour déterminer la configuration réalisant l'adaptation d'impédance.

Cette étape peut être mise en œuvre comme expliqué dans le document US 2009/0130991 précité. Toutefois, comme l'algorithme itératif est initialisé par une configuration d'adaptation d'impédance - donc proche de l'optimalité - sa convergence est rapide.

L'invention a été décrite en référence à un mode de réalisation particulier, mais elle ne s'y limite pas. Par exemple, le premier et le deuxième dispositif à radiofréquence peuvent ne pas être une antenne et un amplificateur de puissance ou à bas bruit ; il n'est d'ailleurs pas indispensable que la chaîne à radiofréquence soit une chaîne d'émission ou de réception. En outre, le réseau d'adaptation d'impédance peut ne pas présenter une topologie en « Pi » mais, par exemple, une topologie en « Te » ou d'un type plus complexe.

**Revendications**

1. Procédé d'adaptation automatique d'impédance d'une chaîne à radiofréquence comprenant : un réseau d'adaptation d'impédance (RAC) ayant une entrée et une sortie, un premier dispositif à radiofréquence (DRF1) connecté à ladite entrée et un deuxième dispositif à radiofréquence (DRF2) connecté à ladite sortie, ledit réseau d'adaptation d'impédance présentant une topologie reconfigurable et comprenant une pluralité d'éléments réactifs ($C_A$, $L_A$, $C_B$, $L_B$, $C_C$, $L_C$) dont au moins un présente une réactance variable et ayant des pertes résultants de leurs composantes résistives parasites, le procédé comprenant les étapes suivantes :

  a) mesurer au moins un courant et une tension à l'entrée ou à la sortie dudit réseau d'adaptation d'impédance (RAC) ;
  b) calculer une impédance complexe $Z_m$, définie par le rapport entre la tension et le courant mesurés en tenant compte de leur déphasage et représentant une impédance d'entrée dudit réseau d'adaptation d'impédance (RAC) ou une impédance de sortie dudit réseau d'adaptation d'impédance (RAC), selon que les mesures de l'étape a) aient été effectuées à l'entrée ou à la sortie dudit réseau d'adaptation d'impédance ;
  c) à partir de ladite impédance complexe $Z_m$, de la topologie et des valeurs actuelles connues des éléments réactifs dudit réseau d'adaptation d'impédance, calculer la valeur d'une impédance complexe $Z_d$ représentative d'une impédance de sortie dudit premier dispositif à radiofréquence (DRF1) ou d'une impédance d'entrée dudit deuxième dispositif à radiofréquence (DRF2), selon que les mesures de l'étape a) aient été effectuées à l'entrée ou à la sortie dudit réseau d'adaptation d'impédance ;
  d) pour une pluralité de topologies possibles dudit réseau d'adaptation d'impédance, calculer des nouvelles valeurs de réactance dudit ou de chaque dit élément réactif présentant une réactance variable, de telle sorte que l'impédance de charge $Z_{DME}$ dudit premier dispositif (DRF1) à radiofréquence ou l'impédance d'entrée $Z_{DSM}$ dudit deuxième dispositif à radiofréquence (DRF2) prenne une valeur aussi proche que possible d'une valeur nominale prédéfinie $Z_{opt}$ ;
  e) choisir, parmi lesdites topologies dudit réseau d'adaptation d'impédance, celle qui minimise les pertes lorsque la réactance dudit ou de chaque dit élément réactif présentant une réactance variable prend la valeur calculée à l'étape d) ; et
  f) configurer le réseau d'adaptation d'impédance de telle sorte qu'il prenne la topologie déterminée à l'étape e) et que la réactance dudit ou de chaque dit élément réactif présentant une réactance variable prenne la valeur calculée à l'étape d).

2. Procédé selon la revendication 1, dans lequel les mesures de l'étape a) sont effectuées à la sortie dudit réseau d'adaptation d'impédance, le procédé comprenant également l'étape suivante, mise en œuvre après ladite étape f) :

g) calculer la puissance électrique (W) en sortie dudit réseau d'adaptation d'impédance à partir de la tension et du courant mesurés, et ajuster itérativement la réactance dudit ou de chaque dit élément réactif présentant une réactance variable de manière à maximiser ladite puissance électrique.

3. Procédé selon l'une des revendications précédentes, dans lequel ledit premier dispositif à radiofréquence est ou comprend un amplificateur de puissance (AP) et ledit deuxième dispositif à radiofréquence est ou comprend une antenne (ANT).

4. Procédé selon l'une des revendications 1 ou 2, dans lequel ledit premier dispositif à radiofréquence est ou comprend une antenne (ANT) et ledit deuxième dispositif à radiofréquence est ou comprend un amplificateur à bas bruit (ABB).

5. Procédé selon l'une des revendications 1 ou 2, dans lequel ledit premier dispositif à radiofréquence est ou comprend une antenne (ANT) et ledit deuxième dispositif à radiofréquence est ou comprend un amplificateur à bas bruit (ABB), le procédé comprenant également l'étape suivante, mise en œuvre après ladite étape f) :

g') mesurer la puissance électrique (W) en sortie dudit amplificateur à bas bruit, et ajuster itérativement la réactance dudit ou de chaque dit élément réactif présentant une réactance variable de manière à maximiser ladite puissance électrique.

6. Module d'adaptation automatique d'impédance configuré pour être agencé entre un premier dispositif à radiofréquence (DRF1) et un deuxième dispositif à radiofréquence (DRF2), ledit module comprenant :

- un réseau d'adaptation d'impédance (RAC) ayant une entrée configuré pour être relié audit premier dispositif à radiofréquence et une sortie configuré pour être reliée audit deuxième dispositif à radiofréquence, ledit réseau d'adaptation d'impédance comprenant une pluralité d'éléments réactifs ($C_A$, $L_A$, $C_B$, $L_B$, $C_C$, $L_C$) dont au moins un présente une réactance variable ;
- un dispositif de mesure de courant et de tension (DME, DMS), agencé pour mesurer un courant et une tension à l'entrée ou à la sortie dudit réseau d'adaptation d'impédance ;
- au moins un premier dispositif de configuration (DC1) dudit réseau d'adaptation d'impédance, configuré pour modifier la réactance dudit ou de chaque dit élément réactif présentant une réactance variable ; et

- un processeur de données (PD) configuré pour recevoir en entrée des mesures de courant et de tension en provenance dudit dispositif de mesure et pour fournir en sortie des signaux de pilotage dudit ou desdits premiers dispositifs de configuration ;

où :

- ledit réseau d'adaptation d'impédance présente une topologie reconfigurable ;
- le module comprend également au moins un deuxième dispositif de configuration (DC2) dudit réseau d'adaptation d'impédance, configuré pour modifier sa topologie ;
- ledit processeur de données est configuré pour : calculer une impédance complexe $Z_m$, définie par le rapport entre la tension et le courant mesurés par ledit dispositif de mesure en tenant compte de leur déphasage et représentant une impédance d'entrée dudit réseau d'adaptation d'impédance (RAC) ou une impédance de sortie dudit réseau d'adaptation d'impédance (RAC), selon que ledit dispositif de mesure soit agencé pour effectuer des mesures à l'entrée ou à la sortie dudit réseau d'adaptation d'impédance ; à partir de ladite impédance complexe $Z_m$, de la topologie et des valeurs actuelles connues des éléments réactifs dudit réseau d'adaptation d'impédance, calculer la valeur d'une impédance complexe $Z_d$ représentative d'une impédance d'entrée dudit premier dispositif à radiofréquence (DRF1) ou d'une impédance de sortie dudit deuxième dispositif à radiofréquence (DRF2), selon que ledit dispositif de mesure soit agencé pour effectuer des mesures à l'entrée ou à la sortie dudit réseau d'adaptation d'impédance ; pour une pluralité de topologies possibles dudit réseau d'adaptation d'impédance, calculer des nouvelles valeurs de réactance dudit ou de chaque dit élément réactif présentant une réactance variable, de telle sorte que l'impédance de charge $Z_{DME}$ dudit premier dispositif (DRF1) à radiofréquence ou l'impédance d'entrée $Z_{DSM}$ dudit deuxième dispositif à radiofréquence (DRF2) prenne une valeur aussi proche que possible d'une valeur nominale prédéfinie $Z_{opt}$ ; choisir, parmi lesdites topologies dudit réseau d'adaptation d'impédance, celle qui minimise les pertes lorsque la réactance dudit ou de chaque dit élément réactif présentant une réactance variable prend la valeur calculée ; générer des signaux de pilotage desdits premiers et deuxièmes dispositifs de configuration adaptés pour que lesdits dispositifs configurent le réseau d'adaptation d'impédance de telle sorte qu'il prenne la topologie choisie et que ledit ou de chaque dit élément réactif présentant une réactance variable prenne la valeur calculée.

7. Module d'adaptation d'impédance selon la revendication 6, dans lequel ledit processeur de données est également configuré pour recevoir en entrée une mesure de puissance électrique (W), ou des données permettant de calculer une puissance électrique, et pour générer des signaux de pilotage dudit ou desdits premiers dispositifs de configuration adaptés pour que lesdits dispositifs ajustent itérativement la réactance dudit ou de chaque dit élément réactif présentant une réactance variable de manière à maximiser ladite puissance électrique.

8. Module d'adaptation d'impédance selon la revendication 7, dans lequel ledit processeur de données est configuré pour calculer ladite puissance électrique à partir des mesures de courant et de tension en provenance dudit dispositif de mesure.

9. Module d'adaptation d'impédance selon la revendication 7 comprenant également un dispositif de mesure de puissance agencé pour mesurer une puissance électrique de sortie dudit deuxième dispositif à radiofréquence et pour fournir un résultat de mesure audit processeur de données.

10. Chaîne d'émission radiofréquence comprenant un amplificateur de puissance (AP), une antenne (ANT) et un module d'adaptation automatique d'impédance selon l'une des revendications 6 à 9 connecté entre une sortie dudit amplificateur de puissance et un port d'entrée de ladite antenne.

11. Chaîne de réception radiofréquence comprenant une antenne (ANT), un amplificateur à bas bruit (ABB) et un module d'adaptation automatique d'impédance selon l'une des revendications 6 à 9 connecté entre un port de sortie de ladite antenne et une entrée dudit amplificateur à bas bruit.

**Patentansprüche**

1. Verfahren zur automatischen Impedanzanpassung einer Hochfrequenzkette, die Folgendes umfasst: ein Impedanzanpassungsnetzwerk (RAC) mit einem Eingang und einem Ausgang, ein mit dem Eingang verbundenes erstes Hochfrequenzgerät (DRF1) und ein mit dem Ausgang verbundenes zweites Hochfrequenzgerät (DRF2), wobei das Impedanzanpassungsnetzwerk eine umkonfigurierbare Topologie aufweist und eine Vielzahl von reaktiven Elementen $(C_A, L_A, C_B, L_B, C_C, L_C)$ umfasst, von denen mindestens eines eine variable Reaktanz aufweist und Verluste hat, die aus ihren parasitären Widerstandskomponenten resultieren, wobei das Verfahren die folgenden Schritte umfasst:

a) Messen mindestens eines Stroms und einer Spannung am Eingang oder am Ausgang des Impedanzanpassungsnetzwerks (RAC);

b) Berechnen einer komplexen Impedanz $Z_m$, definiert durch das Verhältnis zwischen der gemessenen Spannung und dem gemessenen Strom unter Berücksichtigung ihrer Phasenverschiebung und mit einer Eingangsimpedanz des Impedanzanpassungsnetzwerks (RAC) oder einer Ausgangsimpedanz des Impedanzanpassungsnetzwerks (RAC), je nachdem, ob die Messungen von Schritt a) am Eingang oder am Ausgang des Impedanzanpassungsnetzwerks durchgeführt wurden;

c) Berechnen, auf der Basis der komplexen Impedanz $Z_m$, der Topologie und der bekannten aktuellen Werte der reaktiven Elemente des Impedanzanpassungsnetzwerks, des Wertes einer komplexen Impedanz $Z_d$, die für eine Ausgangsimpedanz des ersten Hochfrequenzgeräts (DRF1) oder eine Eingangsimpedanz des zweiten Hochfrequenzgeräts (DRF2) repräsentativ ist, je nachdem, ob die Messungen von Schritt a) am Eingang oder am Ausgang des Impedanzanpassungsnetzwerks durchgeführt wurden;

d) Berechnen, für eine Vielzahl von möglichen Topologien des Impedanzanpassungsnetzwerks, neuer Reaktanzwerte des oder jedes reaktiven Elements mit variabler Reaktanz, so dass die Lastimpedanz $Z_{DME}$ des ersten Hochfrequenzgeräts (DRF1) oder die Eingangsimpedanz $Z_{DSM}$ des zweiten Hochfrequenzgeräts (DRF2) einen Wert annimmt, der so nahe wie möglich an einem vordefinierten anfänglichen Nennwert $Z_{opt}$ liegt;

e) Auswählen, aus den Topologien des Impedanzanpassungsnetzwerks, derjenigen, die die Verluste minimiert, wenn die Reaktanz des oder jedes reaktiven Elements mit einer variablen Reaktanz den in Schritt d) berechneten Wert annimmt; und

f) Konfigurieren des Impedanzanpassungsnetzwerks, so dass es die in Schritt e) bestimmte Topologie annimmt und die Reaktanz des oder jedes reaktiven Elements mit einer variablen Reaktanz den in Schritt d) berechneten Wert annimmt.

2. Verfahren nach Anspruch 1, wobei die Messungen von Schritt a) am Ausgang des Impedanzanpassungsnetzwerks durchgeführt werden, wobei das Verfahren auch den folgenden Schritt umfasst, der nach Schritt f) durchgeführt wird:

g) Berechnen der elektrischen Leistung (W) am Ausgang des Impedanzanpassungsnetzwerks aus der gemessenen Spannung und des gemessenen Stroms und iteratives Einstellen der Reaktanz des oder jedes reaktiven Elements mit einer variablen Reaktanz, um die elektrische Leistung zu maximieren.

3. Verfahren nach einem der vorherigen Ansprüche, wobei das erste Hochfrequenzgerät ein(en) Leistungsverstärker (AP) ist oder umfasst und das zweite Hochfrequenzgerät eine Antenne (ANT) ist oder umfasst.

4. Verfahren nach Anspruch 1 oder 2, wobei das erste Hochfrequenzgerät eine Antenne (ANT) ist oder umfasst und das zweite Hochfrequenzgerät ein(en) rauscharmer/n Verstärker (ABB) ist oder umfasst.

5. Verfahren nach Anspruch 1 oder 2, wobei das erste Hochfrequenzgerät eine Antenne (ANT) ist oder umfasst und das zweite Hochfrequenzgerät ein(en) rauscharmer/n Verstärker (ABB) ist oder umfasst, wobei das Verfahren auch den folgenden Schritt umfasst, der nach Schritt (f) ausgeführt wird:
g') Messen der elektrischen Leistung (W) am Ausgang des rauscharmen Verstärkers und iteratives Einstellen der Reaktanz des oder jedes reaktiven Elements mit einer variablen Reaktanz, um die elektrische Leistung zu maximieren.

6. Automatisches Impedanzanpassungsmodul, welches so konfiguriert ist, dass es zwischen einem ersten Hochfrequenzgerät (DRF1) und einem zweiten Hochfrequenzgerät (DRF2) angeordnet werden kann, wobei das Modul Folgendes umfasst:

- ein Impedanzanpassungsnetzwerk (RAC) mit einem Eingang, der zum Verbinden mit dem ersten Hochfrequenzgerät konfiguriert ist, und einem Ausgang, der zum Verbinden mit dem zweiten Hochfrequenzgerät konfiguriert ist, wobei das Impedanzanpassungsnetzwerk eine Vielzahl von reaktiven Elementen ($C_A$, $L_A$, $C_B$, $L_B$, $C_C$, $L_C$) umfasst, von denen mindestens eines eine variable Reaktanz aufweist;
- ein Strom- und Spannungsmessgerät (DME, DMS), das zum Messen eines Stroms und einer Spannung am Eingang oder am Ausgang des Impedanzanpassungsnetzwerks ausgelegt ist;
- mindestens ein erstes Konfigurationsgerät (DC1) des Impedanzanpassungsnetzwerks, das zum Ändern der Reaktanz des oder jedes reaktiven Elements mit einer variablen Reaktanz konfiguriert ist; und
- einen Datenprozessor (PD), der zum Empfangen von Strom- und Spannungsmesswerten von dem Messgerät als Eingang und zum Liefern von Ansteuersignalen von dem/den ersten Konfigurationsgerät(en) als Ausgang konfiguriert ist;

wobei:

- das Impedanzanpassungsnetzwerk eine umkonfigurierbare Topologie hat;
- das Modul auch mindestens ein zweites Konfigurationsgerät (DC2) des Impedanzanpassungsnetzwerks umfasst, konfiguriert zum Modifizieren seiner Topologie;
- der Datenprozessor konfiguriert ist zum: Berechnen einer komplexen Impedanz $Z_m$, definiert durch das Verhältnis zwischen der Spannung und dem Strom, die von dem Messgerät unter Berücksichtigung ihrer Phasenverschiebung gemessen werden, und die eine Eingangsimpedanz des Impedanzanpassungsnetzwerks (RAC) oder eine Ausgangsimpedanz des Impedanzanpassungsnetzwerks (RAC) darstellt, je nachdem, ob das Messgerät zum Durchführen von Messungen am Eingang oder am Ausgang des Impedanzanpassungsnetzwerks ausgelegt ist; auf der Basis der komplexen Impedanz $Z_m$ der Topologie und der bekannten aktuellen Werte der reaktiven Elemente des Impedanzanpassungsnetzwerks, Berechnen des Wertes einer komplexen Impedanz $Z_d$, die eine Eingangsimpedanz des ersten Hochfrequenzgeräts (DRF1) oder eine Ausgangsimpedanz des zweiten Hochfrequenzgeräts (DRF2) darstellt, je nachdem, ob das Messgerät zum Durchführen von Messungen am Eingang oder am Ausgang des Impedanzanpassungsnetzwerks ausgelegt ist; für eine Vielzahl von möglichen Topologien des Impedanzanpassungsnetzwerks, Berechnen neuer Reaktanzwerte des oder jedes reaktiven Elements mit einer variablen Reaktanz, so dass die Lastimpedanz $Z_{DME}$ des ersten Hochfrequenzgeräts (DRF1) oder die Eingangsimpedanz $Z_{DSM}$ des zweiten Hochfrequenzgeräts (DRF2) einen Wert annimmt, der so nahe wie möglich an einem vordefinierten Nennwert $Z_{opt}$ liegt; Auswählen, aus den Topologien des Impedanzanpassungsnetzwerks, derjenigen, die Verluste minimiert, wenn die Reaktanz des oder jedes reaktiven Elements mit einer variablen Reaktanz den berechneten Wert annimmt; Erzeugen von Ansteuersignalen des ersten und zweiten angepassten Konfigurationsgeräts, um zu bewirken, dass die Geräte das Impedanzanpassungsnetzwerk so konfigurieren, dass es die ausgewählte Topologie annimmt, und um zu bewirken, dass das oder jedes reaktive Element mit einer variablen Reaktanz den berechneten Wert annimmt.

7. Impedanzanpassungsmodul nach Anspruch 6, wobei der Datenprozessor auch konfiguriert ist zum Empfangen eines elektrischen Leistungsmesswertes (W) oder von Daten als Eingang, die das Berechnen einer elektrischen Leistung zulassen, und zum Erzeugen von Ansteuersignalen der ein oder mehreren ersten Konfigurationsgeräte, die so angepasst sind, dass die Geräte die Reaktanz des oder jedes reaktiven Elements mit variabler Reaktanz iterativ einstellen, um die elektrische Leistung zu maximieren.

8. Impedanzanpassungsmodul nach Anspruch 7, wobei der Datenprozessor zum Berechnen der elektrischen Leistung aus den Strom- und Spannungsmesswerten des Messgeräts konfiguriert ist.

9. Impedanzanpassungsmodul nach Anspruch 7, das auch ein Leistungsmessgerät umfasst, das zum Messen einer elektrischen Ausgangsleistung des zweiten Hochfrequenzgeräts und zum Bereitstellen eines Messergebnisses an den Datenprozessor angeordnet ist.

10. Hochfrequenzsendekette die einen Leistungsverstärker (AP), eine Antenne (ANT) und ein automatisches Impedanzanpassungsmodul nach einem der Ansprüche 6 bis 9 umfasst, das zwischen einem Ausgang des Leistungsverstärkers und einem Eingangsport der Antenne verbunden ist.

11. Hochfrequenzempfangskette, die eine Antenne (ANT), einen rauscharmen Verstärker (ABB) und ein automatisches Impedanzanpassungsmodul nach einem der Ansprüche 6 bis 9 umfasst, das zwischen einem Ausgangsport der Antenne und einem Eingangsanschluss des rauscharmen Verstärkers verbunden ist.

## Claims

1. An automatic impedance matching method of a radio-frequency chain comprising: an impedance matching network (RAC) having an input and an output, a first radio-frequency device (DRF1) connected to said input and a second radio-frequency device (DRF2) connected to said output, said impedance matching network having a reconfigurable topology and comprising a plurality of reactive elements ($C_A$, $L_A$, $C_B$, $L_B$, $C_C$, $L_C$), at least one of which exhibits a variable reactance and having losses resulting from their interfering resistive components, the method comprising the following steps of:

   a) measuring at least a current and a voltage at the input or at the output of said impedance matching network (RAC);
   b) computing a complex impedance $Z_m$, defined by the ratio between the voltage and the current that are measured by taking account of their phase shift and representing an input impedance of said impedance matching network (RAC) or an output impedance of said impedance matching network (RAC), depending on whether the measurements in step a) have been taken at the input or at the output of said impedance matching network;
   c) from said complex impedance $Z_m$, from the topology and from the known present values of the reactive elements of said impedance matching network, computing the value of a complex impedance $Z_d$ that is representative of an output impedance of said first radio-frequency device (DRF1) or of an input impedance of said second radio-frequency device (DRF2), depending on whether the measurements in step a) have been taken at the input or at the output of said impedance matching network;
   d) for a plurality of possible topologies of said impedance matching network, computing new reactance values for said or for each said reactive element having a variable reactance, so that the load impedance $Z_{DME}$ of said first radio-frequency device (DRF1) or the input impedance $Z_{DSM}$ of said second radio-frequency device (DRF2) takes a value as close as possible to a predefined nominal value $Z_{opt}$;
   e) choosing, among said topologies of said impedance matching network, the one that minimizes losses when the reactance of said or of each said reactive element having a variable reactance takes the value computed in step d); and
   f) configuring the impedance matching network so that it takes the topology determined in step e) and so that the reactance of said or of each said reactive element having a variable reactance takes the value computed in step d).

2. The method according to claim 1, wherein the measurements in step a) are taken at the output of said impedance matching network, the method also comprising the following step, which is implemented after said step f):
   g) computing the electrical power (W) at the output of said impedance matching network from the measured voltage and current, and iteratively adjusting the reactance of said or of each said reactive element having a variable reactance so as to maximize said electrical power.

3. The method according to one of the preceding claims, wherein said first radio-frequency device is or comprises a power amplifier (AP) and said second radio-frequency device is or comprises an antenna (ANT).

4. The method according to one of claim 1 or 2, wherein said first radio-frequency device is or comprises an antenna (ANT) and said second radio-frequency device is or comprises a low-noise amplifier (ABB).

5. The method according to one of claim 1 or 2, wherein said first radio-frequency device is or comprises an antenna (ANT) and said second radio-frequency device is or comprises a low-noise amplifier (ABB), the method also comprising the following step, which is implemented after said step f):

   g') measuring the electrical power (W) at the output of said low-noise amplifier, and iteratively adjusting the reactance of said or of each said reactive element having a variable reactance so as to maximize said electrical power.

6. An automatic impedance matching module that is configured to be arranged between a first radio-frequency device (DRF1) and a second radio-frequency device (DRF2), said module comprising:

   - an impedance matching network (RAC) having an input that is configured to be connected to said first radio-frequency device and an output that is configured to be connected to said second radio-frequency device, said impedance matching network comprising a plurality of reactive elements ($C_A$, $L_A$, $C_B$, $L_B$, $C_C$, $L_C$), at least one of which has a variable reactance;
   - a current and voltage measuring device (DME, DMS), which is arranged to measure a current and a voltage at the input or at the output of said impedance matching network;
   - at least one first configuration device (DC1) of said impedance matching network, which is configured to modify the reactance of said or of each said reactive element having a variable reactance; and
   - a data processor (PD) that is configured to receive, as input, current and voltage measurements from said measuring device and to provide, as output, control signals for said first configuration device(s);

   wherein:

   - said impedance matching network has a reconfigurable topology;
   - the module also comprises at least one second configuration device (DC2) of said impedance matching network, which is configured to modify its topology;
   - said data processor is configured to: compute a complex impedance $Z_m$, defined by the ratio between the voltage and the current that are measured by said measuring device by taking account of their phase shift and representing an input impedance of said impedance matching network (RAC) or an output impedance of said impedance matching network (RAC), depending on whether said measuring device is arranged to take measurements at the input or at the output of said impedance matching network; from said complex impedance $Z_m$, from the topology and from the known current values of the reactive elements of said impedance matching network, computing the value of a complex impedance $Z_d$ that is representative of an input impedance of said first radio-frequency device (DRF1) or of an output impedance of said second radio-frequency device (DRF2), depending on whether said measuring device is arranged to take measurements at the input or at the output of said impedance matching network; for a plurality of possible topologies of said impedance matching network, computing new reactance values for said or for each said reactive element having a variable reactance, so that said load impedance $Z_{DME}$ of said first radio-frequency device (DRF1) or said input impedance $Z_{DSM}$ of said second radio-frequency device (DRF2) takes a value as close as possible to a predefined nominal value $Z_{opt}$; choosing, from said topologies of said impedance matching network, the one that minimizes the losses when the reactance of said or of each said reactive element having a variable reactance takes the computed value; generating control signals of said first and second configuration devices that are adapted so that said devices configure the impedance matching network so that it takes the chosen topology and so that said or each said reactive element having a variable reactance takes the computed value.

7. The impedance matching module according to claim 6, wherein said data processor is also configured to receive, as input, an electrical power measurement (W), or data allowing an electrical power to be computed, and to generate control signals of said first configuration device(s) that are adapted so that said devices iteratively adjust the reactance of said or of each said reactive element having a variable reactance so as to maximize said electrical power.

8. The impedance matching module according to claim 7, wherein said data processor is configured to compute said electrical power from the current and voltage measurements from said measuring device.

9. The impedance matching module according to claim 7, also comprising a power measuring device that is arranged to measure an output electrical power from said second radio-frequency device and to provide a measurement result to said data processor.

10. A radio-frequency transmission chain comprising a power amplifier (AP), an antenna (ANT) and an automatic impedance matching module according to one of claims 6 to 9 that is connected between an output of said power amplifier and an input port of said antenna.

11. A radio-frequency reception chain comprising an antenna (ANT), a low-noise amplifier (ABB) and an automatic impedance matching module according to one of claims 6 to 9 that is connected between an output port of said antenna and an input of said low-noise amplifier.

FIG.1A

EP 3 021 484 B1

FIG.1B

FIG.5

MESURE DU COURANT ET DE LA TENSION A L'ENTREE OU A LA SORTIE DU RESEAU D'ADAPTATION D'IMPEDANCE — a

CALCUL DE $Z_m$ A PARTIR DE LA TENSION ET DU COURANT MESURES — b

CALCUL DE $Z_d$ A PARTIR DE $Z_m$ EN FONCTION DES VALEURS ACTUELLES DES REACTANCES DU RESEAU D'ADAPTATION D'IMPEDANCE — c

POUR TOUTES LES TOPOLOGIES

CALCUL DES NOUVELLES VALEURS DES REACTANCES — d

CHOIX DE LA TOPOLOGIE MINIMISANT LES PERTES — e

CONFIGURATION DU RESEAU D'ADAPTATION D'IMPEDANCE — f

OPTIMISATION ITERATIVE DE LA PUISSANCE ELECTRIQUE — g

FIG.2

FIG.3

FIG.4

# RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4375051 A
- US 20090130991 A
- EP 2037576 A
- WO 2011026858 A
- EP 2509222 A
- EP 2509227 A
- US 20130069737 A

**Littérature non-brevet citée dans la description**

- **CASHA, O. ; GRECH, I. ; MICALLEF, J. ; GATT, E. ; MORCHE, D. ; VIALA, B. ; MICHEL, J.P ; VINCENT, P. ; DE FOUCAULD, E.** Utilization of MEMS Tunable Inductors in the design of RF voltage-controlled oscillators. *15th IEEE International Conference on Electronics, Circuits and Systems,* 2008
- **L. COLLOT ; J. LINTIGNAT ; B. VIALA ; D. MORCHE ; J-P. MICHEL ; B. BARELAUD ; B. JARRY.** Reconfigurable Filtering Differential Low Noise Amplifier Using MEMS Tunable Inductor. *Proceedings of the 40th European Microwave Conference,* 2010, 826-829
- **YEHUI HAN ; DAVID J. PERREAULT.** Analysis and Design of High Efficiency Matching Networks. *IEEE Transactions on Power Electronics,* Septembre 2006, vol. 21 (5), 1484-1491